# EUROPÄISCHE PATENTSCHRIFT

(11) **EP 0 645 818 B1**
(45) Veröffentlichungstag und Bekanntmachung des Hinweises auf die Patenterteilung: **21.11.2001**
(21) Anmeldenummer: 94119468.0
(22) Anmeldetag: 02.08.1989
(51) Int. Cl.: H01L 27/02

(54) **Elektronisches, monolithisch integriertes Gerät**
Monolithically integrated electronic apparatus
Appareil électronique intégré monolithique

(30) Priorität: 10.08.1988 DE 3827052; 22.07.1989 DE 3924278
(43) Veröffentlichungstag der Anmeldung: 29.03.1995
(62) Teilanmeldung aus: 89908687.0
(73) Patentinhaber: ROBERT BOSCH GMBH, 70442 Stuttgart (DE)
(72) Erfinder: Conzelmann, Gerhard, Dipl.-Phys., D-70771 Leinfelden-Echterdingen (DE); Kainer, Robert, Dr.-Ing., D-72770 Reutlingen (DE); Fiedler, Gerhard, Dipl.-Ing. (FH), D-72666 Neckartailfingen (DE); Jochen, Peter, Dipl.-Phys., D-72760 Reutlingen (DE)

(56) Entgegenhaltungen:
- EP-A- 0 040 125
- EP-A- 0 261 556

## Beschreibung

### Stand der Technik

Die Erfindung betrifft ein elektronisches, monolithisch integriertes Gerät nach der Gattung des Hauptanspruchs.

Wie bereits in der DE-Patentanmeldung P 38 02 822 vorgeschlagen wurde, werden in Fahrzeugleitungen im hochfrequenten Feldbereich starker Sender Spannungen beachtlicher Amplitude influenziert. Führen solche Leitungen zu elektronischen Geräten, so können diese gestört werden. Die Siebschaltungen gemäß der obengenannten Patentanmeldung ermöglichen grundsätzlich einen störungsfreien Betrieb; sie sind jedoch unter gewissen Bedingungen außerordentlich aufwendig:

Führen nämlich Leitungen zum Anschlußfleck einer monolithisch integrierten Schaltung, der schaltungsbedingt direkt mit einer Komponente verbunden ist, die einen nicht entkoppelbaren pn-Übergang bildet, wie etwa den Kollektor-Substrat-Übergang eines mit offenem Kollektor betriebenen Ausgangstransistors oder eines Längstransistors der Stromversorgung, so sind entweder niederohmige und damit relativ aufwendige Siebschaltungen erforderlich oder aber Richtströme unvermeidlich. Beeinträchtigen diese Richtströme allein die Funktion der Schaltung nicht, so müssen sie auch nicht verhindert werden. Sie injizieren jedoch Minoritätsströme in ihre Umgebung, vornehmlich in das Substrat, von wo aus diese unter dem Einfluß des Dichtegradienten weit in die Fläche der monolithisch integrierten Schaltung hinein diffundieren. Erreichen sie empfindliche Schaltungsteile in hinreichender Stromstärke, so kann deren Arbeitspunkt verlagert und die Funktion der Schaltung bis zum Totalausfall gestört werden. Da die Minoritätsströme grundsätzlich als Folge von Richtströmen auftreten, müssen entweder die Richtströme selbst oder die von ihnen erzeugten Minoritätsströme durch geeignete Mittel verhindert und/oder reduziert bzw. unschädlich gemacht werden.

In elektronischen Systemen können jedoch auch an den obengenannten pn-Übergängen Signalspannungen bzw. durch parasitäre Effekte erzeugte Spannungen auftreten, die negativer sind als das Substrat und die deshalb gleichermaßen Richtströme und die damit verbundenen Minoritätsströme erzeugen.

Aus der Zeitschrift Electronic, July 24 1975, S.31 - 32 ist bereits eine Struktur bekannt, die eingebrachte Minoritäten dämpft. Die integrierte Schaltung mit den Merkmalen des unabhängigen Patentanpruch weist demgegenüber eine verbesserte Dämpfung der Minoritäten auf.

### Zeichnung

Die Erfindung sei anhand der Figuren 1 bis 8 erläutert: Figur 1 zeigt die Schaltung eines Richt- und Minoritätsstrom erzeugenden Transistors 1a sowie eines den Minoritätsstrom empfangenden Transistors 1b; in Figur 2 ist der Zeitverlauf der Kollektorspannung des Richtstrom erzeugenden Transistors unter dem Einfluß einer überlagerten hochfrequenten Wechselspannung dargestellt. Figur 3 zeigt die Beschaltung des Transistors mit einer Reihendiode zum Verhindern eines Richtstroms, Figur 4 eine Paralleldiode zu seiner Reduktion. In Figur 5 sind das Prinzip einer Barriere zum Abfangen des erzeugten Minoritätsstroms, und in Figuren 6a - e die Strukturen erforderlicher Avalanche-, Schottky- bzw. Kapazitätsdioden mit möglichen Zusammenschaltungen (Figuren 7a - c) erläutert. Ferner zeigt Figur 8a eine Schaltung mit einem Transistor, dessen Richtstrom durch eine Reihendiode verhindert wird, und einem weiteren Transistor, dessen in das Substrat injizierter Minoritätsstrom durch eine Barriere abgefangen wird, und Figur 8b einen Schnitt durch die dazugehörende Struktur.

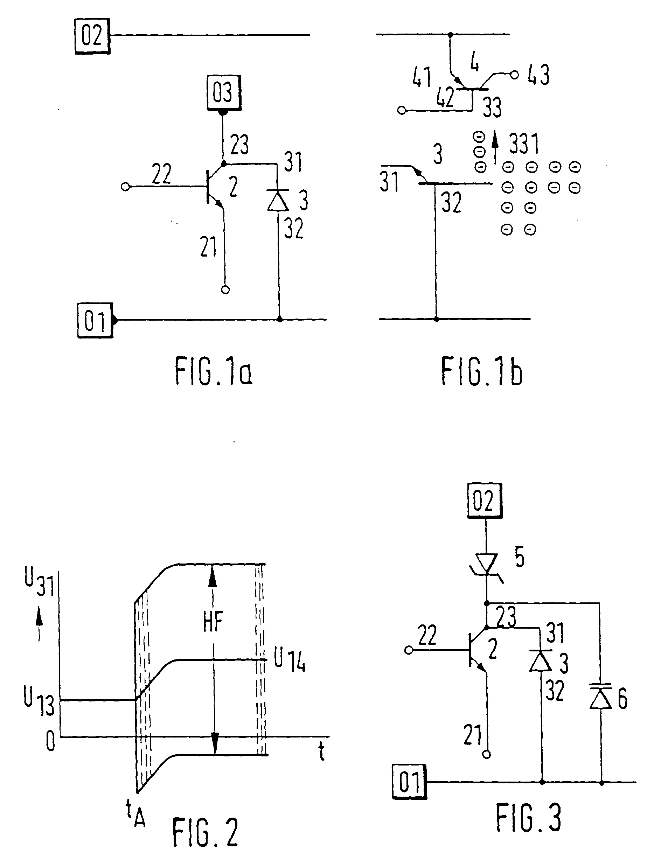

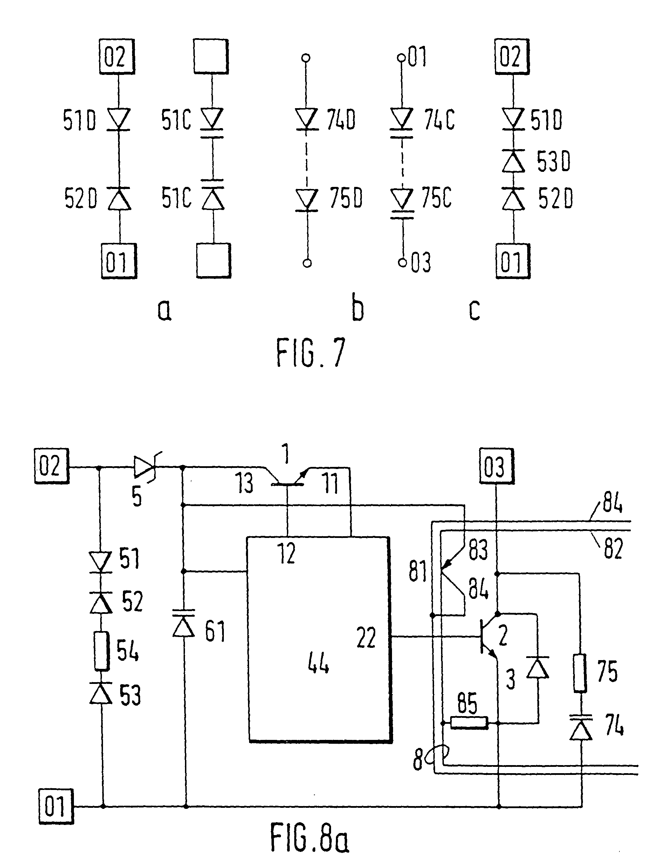

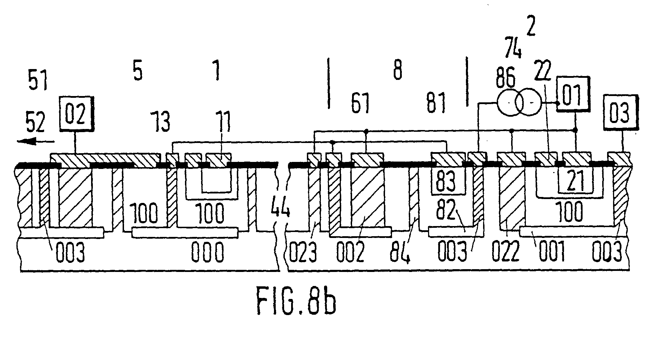

Die Figuren 1 bis 7 dienen hierbes zur Erlänterung des technischen Hintergrunds der in Figur 8 gezeigten Ausführungsbeispele der Erfindung.

### Beschreibung der Erfindung

In Figur 1a ist 01 der masseseitige Anschluß, 02 der Anschluß für den positiven Pol der Betriebsspannung und 2 ein wie gebräuchlich auf einem p-Substrat dargestellter Transistor, 21 sein Emitter, 22 seine Basis und 23 sein Kollektor, der einerseits mit dem Anschlußfleck 03 verbunden ist und andererseits mit dem Substrat als Anode 32 die parasitäre Diode 3 bildet; deren Kathode 31 entspricht somit dem Kollektor 23 von 2. In Figur 1b ist die Anordnung beispielhaft ergänzt durch einen pnp-Transistor 4 mit seinem Emitter 41, seiner Basis 42 und seinem Kollektor 43. Die Substratdiode 3 ist dargestellt als Transistor mit der Kathode 31 als Emitter, dem räumlich ausgedehnten Substrat 32 als Basis und dem weit entfernt liegenden Kollektor 33, der identisch ist mit der an positivem Potential liegenden Basis 42 des pnp-Transistors 4; mit 331 ist der von Elektronen gebildete Minoritätsstrom angedeutet.

In Figur 2 ist der Zeitverlauf des Kollektorpotentials U₃₁ gegen Masse dargestellt. Gerät die an die Anschlußflecken 01, 03 angeschlossene Leitung in das Feld eines starken Senders, so können Amplituden influenziert werden, die weit über das anstehende Gleichpotential U₁₃ hinausgehen; dieser Fall trete zum Zeitpunkt t_{A} ein; es entsteht ein Richtstrom, der das Gleichpotential U₁₃ auf den Wert U₁₄ anhebt. Problematisch ist in der Regel nicht das Anheben des Gleichpotentials U₃₁ des Kollektors 23 von 2, sondern die mit dem Richtstrom verbundene Injektion eines Minoritätsstroms 331 in das Substrat. Darüber hinaus können in elektronischen Systemen auch ohne hochfrequente Einstrahlung Spannungsverläufe mit negativen Spannungen gegen das Substrat auftreten, wie sie etwa dem in Figur 2 fett gekennzeichneten Ast der Einhüllenden entsprechen; auch sie injizieren Minoritäten. Durch die hohe Lebensdauer der Minoritäten ergeben sich im feldfreien Substrat große Diffusionslängen, so daß der Minoritätsstrom auch noch die Arbeitspunkte weit entfernter Komponenten, wie etwa den des Transistors 4, zu verschieben vermag. Ein Zahlenbeispiel soll dies veranschaulichen:

Der Richtstrom betrage 300 mA, der von ihm in das Substrat injizierte Minoritätsstrom sei 10 % davon, also 30 mA. Liegt der Basisstrom von 4 bei 1 µA, was schon reichlich dimensioniert erscheint, so sind bei einer Dämpfung des Minoritätsstroms von 1 : 30 000 beide Ströme erst gleich groß.

In Figur 3 ist wieder an die Anschlußflecken 01, 02 der positive und negative Pol der Betriebsspannung angeschlossen; 2 ist in diesem Beispiel der Längstransistor eines Schaltungsteils zur Spannungsstabilisierung; mit 3 ist die parasitäre Substratdiode, mit 5 eine zwischen den Anschlußfleck 03 und den Kollektor 23 geschaltete Diode und mit 6 eine der Diode 5 nachgeschaltete Kapazität - in diesem Beispiel eine Kapazitätsdiode - bezeichnet. Die Diode 5 verhindert in Verbindung mit dem Kondensator 6 sicher das Polen der Diode 3 in Durchlaßrichtung; der Kondensator 6 ist erforderlich, um ein durch Eigenkapazität und Sperrträgheit der Diode 5 bedingtes restliches Untertauchen des Potentials am Kollektor 23 unter das Massepotential sicher zu verhindern. Ist die an die Diode 5 angeschlossene Schaltung allein schon gegen die restliche überlagerte HF-Amplitude empfindlich, kann der Kondensator 6 darüber hinaus vergrößert werden. Die Diode 5 kann auch durch die Emitter-Basis-Diode eines pnp-Transistors gebildet werden; in diesem Fall ist der Kondensator 6 an den Kollektor des pnp-Transistors anzuschließen. Von dem pn-Übergang 5 etwa erzeugte Minoritäten breiten sich nicht aus, da sie von dem an 23 anstehenden positiven Gleichpotential eingefangen werden.

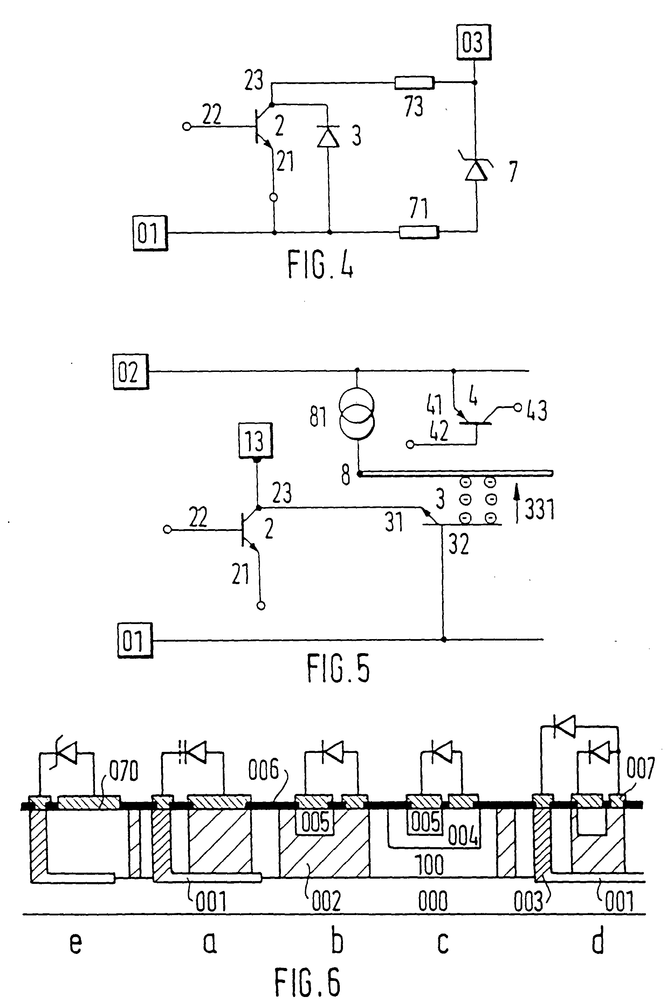

Im Beispiel von Figur 4 liegt der Emitter 21 des npn-Transistors 2 am Anschlußfleck 01, sein Kollektor 23 am Anschlußfleck 03; parallel zu dem bei negativem Kollektorpotential in Durchlaßrichtung gepolten pn-Übergang 3 ist jetzt eine Diode 7 geschaltet, deren Elektroden über die mindestens als Bahnwiderstände vorhandenen Widerstände 71 und/oder 73 mit Emitter 21 und Kollektor 23 verbunden sind; die Diode 7 reduziert eventuell in Verbindung mit den Widerständen 71 und/oder 73 den Richtstrom durch 3; besonders vorteilhaft ist eine Schottkydiode als Diode 7, da sie mit einer erheblich niedrigeren Durchlaßspannung als 3 darstellbar ist und nahezu keine Minoritäten injiziert.

Nicht immer läßt sich die Injektion eines Minoritätsstroms ganz vermeiden oder hinreichend reduzieren. In diesem Fall hilft das Abfangen des Minoritätsstroms mittels einer Barriere. In Figur 5 ist in das Beispiel von Figuren 1a, b die mit 8 bezeichnete Barriere zwischen die als npn-Transistor wirkende Diode 3 und den durch den Minoritätsstrom zu störenden pnp-Transistor 4 geschaltet. Die Barriere 8 ist über die Stromquelle 81 positiv vorgespannt; sie vermag den gesamten Minoritätsstrom aufzunehmen, sofern der Strom des Stromgenerators 81 hinreichend ergiebig ist; um die notwendigen hohen Ruheströme zu vermeiden, sieht eine vorteilhafte Weiterbildung der Erfindung vor, diesen Strom als eine Funktion des Richt- bzw. Minoritätsstroms auszubilden. Ein mögliches Ausführungsbeispiel wird später anhand der Figuren 8a, b gezeigt werden. Damit der Minoritätsstrom sicher abgefangen wird, sollte die Barriere entweder die kritischen Teile der monolithisch integrierten Schaltung oder aber die Minoritätsströme injizierenden Komponenten umschließen. Besonders vorteilhaft ist, letztere am Chiprand anzuordnen und die hinreichend breite Barriere 8 von Chiprand zu Chiprand über Eck oder gerade durch gehen zu lassen. Außerdem ist es vorteilhaft, im Layout unmittelbar anschließend an die Barriere 8 die gegen Minoritätsströme unempfindlicheren Teile der monolithisch integrierten Schaltung anzuordnen, wodurch sich der Aufwand für eine störsichere Schaltung reduzieren läßt. Üblicherweise wird die Störsicherheit nur für bestimmte Grenzfeldstärken der störenden Sender bzw. bestimmte Grenzrichtströme gefordert. In der Praxis können jedoch auch noch höhere Feldstärken bzw. Richtströme vorkommen, so daß die angewandten Schutzmittel versagen. Für diesen Fall ist es zweckmäßig, dafür zu sorgen, daß das Gesamtsystem in einen möglichst ungefährlichen Zustand übergeht. Folgende Beispiele seien genannt:
1. Ein Regler für große Ströme (etwa 30 A) könne durch einen Minoritätsstrom durchgehen, sobald dieser den Regelkreis durchbricht; da der Leistungstransistor eine niedrige Sättigungsspannung aufweisen soll, könnte er bei direkter Ansteuerung außerhalb der Sättigung noch sehr viel höhere Ströme (etwa 50 - 100 A) ziehen. Dies läßt sich sicher dadurch vermeiden, daß beispielsweise die Komponente des strombestimmenden Stromspiegels, die durch Aufnehmen eines Minoritätsstroms den Strom des Leistungstransistors abregelt, im Layout bevorzugt im Einzugsbereich des Minoritätsstroms angeordnet ist.
2. Ein Hallsensor im Zündverteiler eines Kraftfahrzeugs mit einer digitalen Motorsteuerung diene allein zur Bestimmung des Zylinders 1; er darf während des Betriebs momentan ausfallen, sofern er die Zündung nicht beeinflußt; dies ist dann der Fall, wenn der Kollektor 23 seines Ausgangsstransistors nicht in den durchgeschalteten Zustand übergeht. Auch diese Forderung ist durch die Anordnung der entsprechenden Komponenten im Layout für den Fachmann leicht einzuhalten.

In den Figuren 6a bis 6e ist beispielhaft ein möglicher Prozeß zur Darstellung anhand eines Schnittbildes der Strukturen etwa erforderlicher Avalanche-, Schottky- bzw. Kapazitäts-Dioden wiedergegeben. Es bedeuten:

| | |
|---|---|
| 000 | Substrat |
| 001 | "buried layer" |
| 002 | Isolierungsdiffusion |
| 100 | Epitaxie |
| 003 | Kollektoranschluß-Diffusion |
| 004 | Basisdiffusion |
| 005 | Emitterdiffusion |
| 006 | Deckoxid |
| 007 | Metallisierung |
| 070 | Kontaktfenster |

Auf die Darstellung einer üblichen Schutzschicht aus Plasmanitrid oder dergleichen wurde verzichtet.

Die Isolierungsdiffusion 002 ist weit, die Kollektoranschluß-Diffusion 003 eng von links unten nach rechts oben, das strukturierte Metall 007 dagegen von links oben nach rechts unten schraffiert wiedergegeben.

Die Diode nach Figur 6a ist mittels der auf dem buried layer 001 aufsitzenden Isolierungsdiffusion 002 gebildet; je nach Führung der Herstellungsprozesse ergeben sich Durchbruchspannungen zwischen etwa 10 und 25 V. Die Diode nach Figur 6b ist mittels einer innerhalb der Isolierungsdiffusion 002 liegenden Emitterdiffusionszone 005 gebildet mit einer niedrigeren Durchbruchspannung von ca. 6 V, dafür aber einem höheren Kapazitätsbelag. In Figur 6c ist die übliche Basis(004)-Emitterdiode (005) dargestellt; sie besitzt einen größeren Bahnwiderstand, ist dafür jedoch gegen das Substrat 000 durch den n-dotierten Raum 100 (Epitaxie) üblicherweise höhersperrend isoliert. Die Diode nach Figur 6d ist aus den Zonen buried layer (001) und Emitter (005) gegen die Isolierung (002) in einer Sandwich-Anordnung gebildet, wobei der buried layer über die Kollektoranschluß-Diffusion 003 herausgeführt ist. Wird 005 mit 003 verbunden, so ergibt sich eine größere Kapazität. Wird dagegen nur 005 gegen 002 genutzt, so ergibt sich durch die doppelte Sperrschichtisolierung eine Diode nach 6b in bipolarer Ausführung. Die Schottkydiode nach Figur 6e ist beispielsweise direkt mit einer Al-Elektrode als Anode 511 und der n-dotierten Epitaxie 100 als Kathode gebildet; auf Maßnahmen zur Unterdrückung der Feldemission durch Spitzenwirkung entlang des Kontaktfensterrands wurde hier nicht eingegangen, da bei niedrigen Sperrspannungen darauf verzichtet werden kann; wenn nicht, können sie der Literatur entnommen werden.

Die Anordnungen nach Figur 6 lassen sich der Aufgabe entsprechend auch als Avalanchedioden oder Kapazitätsdioden verwenden. Als Avalanchediode ist ihre Fläche entsprechend der aufzunehmenden Stoßenergie, als Kapazitätsdiode entsprechend der geforderten Kapazität auszulegen. Um den vielfältigen Forderungen einer Schaltung besser gerecht zu werden, lassen sich die Dioden nach Figur 6, wie an einigen Beispielen der Figuren 7a - c gezeigt ist, beliebig kombinieren.

In Figur 8a ist der Gegenstand der Erfindung anhand einer beispielhaften Schaltung erläutert: Mit 01, 02 sind wieder die Anschlußflecken für die negative (Masse) und die positive Betriebsspannung, mit 03 der Anschlußfleck für den Kollektor des Ausgangstransistors bezeichnet. Die Dioden 51, 52 und 53 mit ihrem Innenwiderstand 54 dienen dem Schutz der Schaltung gegen der Betriebsspannung überlagerte Spannungsspitzen; ist ihre Kapazität hinreichend groß, so können sie auch nach Patentanmeldung P 38 02 822 zur Dämpfung der an 02/01 angeschlossenen Leitung dienen; durch die gegengeschaltete Diode 51 wird die gesamte Schaltung verpolungsfest. Ferner ist 5 eine Schottkydiode nach Figur 3 zum Unterdrücken der sonst durch hochfrequente Wechselspannungen erzeugten Richtströme im Kollektorkreis des Längstransistors 1 (entsprechend 2 von Figur 3); der Ausgang der Diode 5 ist durch die Diode 61 kapazitiv mit Masse 01 verbunden. Der Ausgangstransistor ist mit 2 bezeichnet. Da sich die durch hochfrequente Wechselspannungen entstehenden Richt- und Minoritätsströme wegen der Forderung nach einer niedrigen Sättigungsspannung von 2 nicht verhindern lassen, ist die Barriere 8 zwischen den Ausgangstransistor 2 und den mit 44 bezeichneten aktiven Teil der monolithisch integrierten Schaltung angeordnet. Die Diode 74 mit dem (Bahn-)Widerstand 75 dient zum Schutz des Transistors 2 gegen Überspannungen und eventuell auch zur weiteren Dämpfung der am Anschlußfleck 03 angeschlossenen Leitung. Die Barriere 8 besteht aus zwei Teilen: einer vorgelagerten Rekombinationszone, die aus der mittels der Epitaxie eventuell in Verbindung mit der buried-layer-Diffusion erzeugten Sperrschicht 82 besteht und die über die als Emitter wirkende in ihr sich befindende p-dotierte Zone 83 am kathodenseitigen Ende der Diode 5 - also an wechselspannungsarmer Betriebsspannung - angeschlossen ist; sie bilden Basis 82 und Emitter 83 des als Stromquelle 81 dienenden pnp-Transistors, dessen Kollektor gleich der als ohmscher Substratkontakt wirkenden Zone 84 zum Absaugen des Minoritätsstroms ist; der in das Substrat fließende Strom wird somit durch den Minoritätsstrom selbst erzeugt. Der Transistor 81 kann auch als Darlington ausgebildet sein, um einen zum Absaugen des gesamten Minoritätsstroms ausreichenden Kollektorstrom sicherzustellen. Wegen des relativ großen aufzunehmenden Stroms kann der Emitter 83 auch direkt am Anschlußfleck 02 für die Betriebsspannung liegen bzw. auch über eine eigene Diode dort angeschlossen sein.

Die durch die Zone 84 im Substrat erzeugte vertikale Feldkomponente wirkt auch noch in der Umgebung der Rekombinationszone 82 und erhöht deren Rekombinationsstrom und somit auch den Basisstrom des pnp-Transistors 81. Während bei großen Minoritätsströmen infolge des hohen Dichtegradienten genügend Rekombinationsstrom auf die Basis 82 fließt, kann er bei kleinen Strömen nicht ausreichen; mittels des Widerstands 85 (Figur 8 a) bzw. der Stromquelle 86 (Figur 8 b) wird ein hinreichender Vorstrom auf die Basis 82 erzeugt.

Zu den Komponenten 51, 5, 1, 44, 61, 8, 74 und 2 ist die Struktur einer möglichen Anordnung im Layout in der Figur 8b wiedergegeben; am linken Rand ist noch die Diode 52 angeschnitten. Die einzelnen Zonen der Struktur sind bereits anläßlich der Beschreibung zu Figur 6 erläutert worden. Vom Anschlußfleck 02 ausgehend sind nach links die zur Schutzschaltung gehörenden Dioden 51 und 52 (weiter links käme 53) angeordnet, nach rechts die Schottkydiode 5, die mit dem Längstransistor 1 einen gemeinsamen buried layer aufweist. Anschließend beginnt der mehr oder weniger komplexe aktive Teil 44 der monolithisch integrierten Schaltung. Am äußersten rechten Ende liegt der bei negativem Kollektorpotential Minoritätsströme injizierende Transistor 2. Die Barriere 8 zwischen 2 und 44 wird gebildet durch die Rekombinationselektrode 82 und die Isolierungsdiffusionszone 84 als ohmschem Kontakt zum Substrat und Kollektor des als Stromquelle 81 dienenden pnp-Transistors zum Absaugen des Minoritätsstroms. Zwischen der Barriere 8 und der restlichen Schaltung 44 ist der Kondensator 61 angeordnet; hierdurch wird der Abstand zwischen dem ohmschen Kontakt zum Substrat 84 und der nächstbenachbarten an Masse liegenden Isolierungsdiffusionszone 023 und damit der dazwischenliegende Substratwiderstand vergrößert. Innerhalb des pnp-Transistors 81 ist es vorteilhaft, zwischen die Isolierungsdiffusionszone 022 und den p-dotierten Emitter 83 eine Kollektoranschluß-Diffusionszone 003 zum etwa ganz oder teilweise vorhandenen buried layer 82 einzubringen. In dieser Schaltung ist es in der Regel nicht zweckmäßig, die Diode 5 und den npn-Transistor 1 durch einen pnp-Transistor zu ersetzen, da dieser dann auch den aufzunehmenden Minoritätsstrom, also ein Vielfaches des regulären Betriebsstroms, liefern müßte.

Eine weitere Ausgestaltung der Erfindung sieht vor, Barrieren in den oben beschriebenen Formen um zu schützende Komponenten der Schaltung zu legen, um damit den Gesamtaufwand eventuell zu reduzieren.

Kern der Erfindung sind in eine monolithisch ingetrierte Schaltung einzubringende Mittel, um die unter dem Einfluß hochfrequenter Wechselspannungen, Signalspannungen bzw. parasitärer Effekte in das Substrat injizierten Minoritätsströme zu dämpfen. Hierdurch wird es in vielen Fällen möglich, die Funktion eines elektronischen Systems mit monolithisch integrierten Schaltungen ohne zusätzlichen Aufwand an diskreten Komponenten sicherzustellen bzw. im Falle eingestrahlter Störspannungen auf etwa in Steckverbindungen nur schwierig unterzubringende Entstörmittel ganz zu verzichten oder mindestens den Aufwand dafür zu reduzieren.

## Patentansprüche

1. Integrierte Schaltung mit einem Substrat (000), einem auf dem Substrat angeordneten pn-Übergang (3), wobei der pn-Übergang mit einem Anschlußfleck der integrierten Schaltung verbunden und im Arbeitsbetrieb der Schaltung gesperrt ist und durch Störungen in Durchlaßrichtung polbar ist und dann einen Minoritätsstrom in das Substrat injiziert, einer Barriere (8) zum Rekombinieren des Minoritätsstroms wobei der pn-Übergang (3) von anderen Bauelementen (44) der integrierten Schaltung durch die Barriere (8) getrennt ist, **dadurch gekennzeichnet, daß** die Barriere (8) einen Transistor (81) mit Basis (82) , Emitter (83) und Kollektor (84) aufweist, daß für den Transistor (81) eine an einen Betriebsspannungsanschluß verbundene Emitterzone (83) in eine Epitaxiezone (100) eingebracht ist, daß die Epitaxiezone (100) auf dem Substrat (000) angeordnet ist, daß der Kollektor des Transistors (81) durch das Substrat (000) oder eine als ohmscher Substratkontakt wirkende Zone (84) gebildet ist, um den in das Substrat fließenden Minoritätsstrom abzusaugen, und daß die Basis (82) in die Epitaxiezone (100) eingebracht und über einen ohmschen Widerstand (85) beziehungsweise über die Anschlußzone (003) und eine Stromquelle (86) mit dem auf Massepotential legbaren Anschlußfleck (01) verbunden ist.

2. Integrierte Schaltung nach Anspruch 1, **dadurch gekennzeichnet, daß** der Emitter des Transistors (81) mit einer positiven Betriebsspannung verbunden ist.

3. Integrierte Schaltung nach einem der vorhergehenden Ansprüche, **dadurch gekennzeichnet, daß** die Basis (82) des Transistors (81) mit einem ohmschen Widerstand (85) mit Masse verbunden ist.

4. Integrierte Schaltung nach einem der vorhergehenden Ansprüche, **dadurch gekennzeichnet, daß** der pn-Übergang der zeitweilig in Durchlaßrichtung gepolt ist an der Peripherie der Schaltung angeordnet ist.

## Claims

1. Integrated circuit having a substrate (000), having a pn junction (3) arranged on the substrate, where the pn junction is connected to a pad of the integrated circuit and is reverse-biased during working operation of the circuit and can be forward-biased by interference and then injects a minority current into the substrate, having a barrier (8) for recombining the minority current, the pn junction (3) being isolated from other components (44) of the integrated circuit by the barrier (8), **characterized in that** the barrier (8) has a transistor (81) having base (82), emitter (83) and collector (84), **in that**, for the transistor (81), an emitter zone (83) connected to an operating voltage connection is introduced into an epitaxial zone (100), **in that** the epitaxial zone (100) is arranged on the substrate (000), **in that** the collector of the transistor (81) is formed by the substrate (000) or a zone (84) acting as an ohmic substrate contact, in order to extract the minority current flowing into the substrate, and **in that** the base (82) is introduced into the epitaxial zone (100) and is connected via an ohmic resistor (85) or via the connection zone (003) and a current source (86) to the pad (01), which can be put at earth potential.

2. Integrated circuit according to Claim 1, **characterized in that** the emitter of the transistor (81) is connected to a positive operating voltage.

3. Integrated circuit according to one of the preceding claims, **characterized in that** the base (82) of the transistor (81) is connected to earth by an ohmic resistor (85).

4. Integrated circuit according to one of the preceding claims, **characterized in that** the pn junction which is temporarily forward-biased is arranged on the periphery of the circuit.

## Revendications

1. Circuit intégré comprenant un substrat (000), une jonction pn (3) installée sur le substrat,
la jonction pn étant reliée à une surface de branchement du circuit intégré, et bloquée dans la plage de fonctionnement du circuit en étant polarisable dans le sens passant par les parasites, cette jonction injectant alors un courant minoritaire dans le substrat,
une barrière (8) pour recombiner le courant minoritaire, la jonction pn (3) étant séparée des autres composants (44) du circuit intégré, par la barrière (8),
**caractérisé en ce que**
la barrière (8) comporte un transistor (81) ayant une base (82), un émetteur (83) et un collecteur (84), pour le transistor (81), il est prévu une zone d'émetteur (83) reliée au branchement de tension de fonctionnement dans une zone épitaxiale (100),
la zone épitaxiale (100) est prévus sur le substrat (000) le collecteur du transistor (81) est formé par le substrat (000) ou par une zone (84) fonctionnant comme un contact ohmique de substrat pour aspirer le courant minoritaire passant dans le substrat, et
la base (82) est prévue dans la zone épitaxiale (100) et est reliée, par l'intermédiaire d'une résistance ohmique (85) ou par la zone de branchement (003) et une source de courant (86), à la surface de branchement (01) mise au potentiel de la masse.

2. Circuit intégré selon la revendication 1,
**caractérisé en ce que**
l'émetteur du transistor (81) est relié à une tension de fonctionnement positive.

3. Circuit intégré selon l'une des revendications précédentes,
**caractérisé en ce que**
la base (82) du transistor (81) est reliée à la masse par une résistance ohmique (85).

4. Circuit intégré selon l'une des revendications précédentes,
**caractérisé en ce que**
la jonction pn est polarisée de temps à autre dans le sens passant à la périphérie du circuit.
